# EUROPEAN PATENT APPLICATION

(11) **EP 2 610 650 A1**
(43) Date of publication of application: **03.07.2013**
(21) Application number: 11819776.3
(22) Date of filing: 08.08.2011
(51) Int. Cl.: G02B 5/08, F24J 2/10, G02B 1/10, H01L 31/052

(54) **FILM MIRROR FOR SOLAR THERMAL POWER GENERATION, METHOD FOR PRODUCING FILM MIRROR FOR SOLAR THERMAL POWER GENERATION, AND REFLECTING DEVICE FOR SOLAR THERMAL POWER GENERATION**

(30) Priority: 25.08.2010 JP 2010188013
(71) Applicant: Konica Minolta Opto, Inc., Hachioji-shi Tokyo 192-8505 (JP)
(72) Inventor: MOCHIZUKI, Makoto, Hachioji-shi Tokyo 192-8505 (JP)
(74) Representative: Gille Hrabal
(86) International application number: PCT/JP2011/068041
(87) International publication number: WO 2012/026312

(57) **Abstract**

Disclosed is a film mirror for solar thermal power generation, which has a reflective layer on a substrate and a hard coat layer on the outermost surface. The film mirror for solar thermal power generation is characterized in that a leveling agent containing fluorine atoms is contained in the hard coat layer on the outermost surface in an amount of 0.1-10% by mass (inclusive) of the resin solids in the hard coat layer on the outermost surface.

## Description

### TECHNICAL FIELD

The present invention relates to a film mirror for solar thermal power generation, a method for producing the same, and a reflecting device for solar thermal power generation using the same.

### BACKGROUND ART

In recent years, various natural energies including coal energy, biomass energy, nuclear energy, wind energy and solar energy have been investigated as substitutes for fossil fuel energy such as obtainable from petroleum and natural gas. Among them, solar energy is considered as a most stable and abundant natural energy as the substitutive energy for the fossil fuel energy. Solar energy which is a very promising substitutive energy is, however, supposed to be suffered from problems in (1) low energy density, and (2) difficulties in storage and transmission, from the viewpoint of actualization.

As challenges to the problems in solar energy, one solution ever proposed is a method of condensing solar energy using a huge reflecting device, aiming at overcoming the problem of low energy density. Glass mirror has been used for the reflecting device, since the reflecting device is exposed to ultraviolet radiation and heat of sunlight, wind, rain, sandstorm and so forth. The glass mirror excellent in environment-proof performance is, however, likely to be broken during transportation, or needs a high-strength mount on which the mirror is mounted due to its large weight, and thereby construction of a plant costs high.

On the other hand, film mirror has been known as a mirror for solar thermal power generation, characterized by its light weight, high flexibility, and low costs for manufacturing and transportation. Such a film mirror for solar thermal power generation is used while being exposed to the outdoor at all times, and thus need be protected from scratching due to sandstorm or the like, and need be prevented from degrading in the reflectance due to scratching during cleaning of the film mirror. It is also necessary to prevent degradation in the reflectance due to adhesion of dust or organic substances.

At present, the mirror surface is sprinkled with water and cleaned with a brush to thereby keep high reflectance, wherein large costs are necessary not only for materials for cleaning, but also for labor. Moreover, in the solar thermal power generation, the mirror is installed in environments highly causative of dirt adhesion, such as in desert, and needs frequent cleaning. Increased number of time of cleaning may, however, damage the mirror *per se,* and may degrade the reflectance. As described in the above, techniques regarding outermost hard coat layer having high hardness and antifouling property have been understood as a matter to be solved in the field of film mirror for solar thermal power generation

A known report on the film mirror for solar thermal power generation is exemplified by Patent Literature 1. In this literature, a 61 µm-thick acryl layer is provided as the outermost layer of the film, but has only a limited level of hardness, so that installation of the mirror in a desert with abundant irradiation of sunlight will damage the film surface due to sandstorm and the damage on the film is inevitable. In addition, adhesion of sand or dust on the film will considerably dirty the film surface with time, and will make it difficult to keep the high reflectance for a long period. At present, the mirror surface is sprinkled with water and cleaned with a brush to thereby keep high reflectance, wherein large costs are necessary not only for goods for cleaning, but also for labor. Moreover, in the solar thermal power generation, the mirror is installed in environments highly causative of dirt adhesion, such as in desert, and needs frequent cleaning. Increased number of time of cleaning may, however, damage the mirror *per se,* and may degrade the reflectance.

As a general outermost layer having high hardness and high antifouling property, there has been used a photocatalyst-containing ceramic layer having a hydrophilic surface as described in Patent Literature 2, aiming at forming a water film using rain or atmospheric moisture so as to wash off the dirt on the surface. General mirror surface is covered with glass or resin, and therefore shows contact angle of water of 80° to 90°. It is therefore supposed that a surface having a smaller contact angle may exhibit a certain level of hydrophilicity, and express cleaning ability. Patent Literature 2 describes that a road mirror, as an exemplary mirror with a hydrophilic surface, with the photocatalyst provided to the surface thereof, can decompose pollutant adhered on the surface by virtue of a strong oxidizing power, and can wash the dirt off when the surface was wetted with rain. However, in desert suitable for solar thermal power generation, a main cause of dirt is sand dust which is less degradable by oxidation. In addition, rain is hardly expected in desert, except for a slight adhesion of dew in the nighttime, so that the sand dust adhered in the dry daytime is hardly washed off. It has therefore been considered that the high reflectance was kept only by periodical washing as described in the above. It has also been observed that the surface was degraded in the hardness after formation of the water film on the surface, as a result of washing or dewing in the nighttime, and became more likely to be scratched.

Patent Literature 3 makes a challenge of improving weatherability of a UV-curable acrylic hard coat layer, by adding thereto a benztriazol-based UV absorber of 15% by mass or more relative to a solid resin content. The hard coat described in Patent Literature 3 successfully suppressed the photo-induced degradation such as discoloration of resin after UV exposure, but was degraded in the surface hardness after the formation of water film as a result of washing or dewing in the nighttime, which makes scratching more notable.

As described in the above, there has not been proposed a film mirror suitable for solar thermal power generation, having high reflectance and weatherability, less scratchable, and less fouling even after long-term use.

### Prior Art Literature

### Patent Literature

PATENT LITERATURE 1: Published Japanese Translation ofPCT International Publication for Patent Application No. 2009-520174
PATENT LITERATURE 2: Japanese Laid-Open Patent Publication No. 2000-17620
PATENT LITERATURE 3: United States Patent No. 7,507,776

### SUMMARY OF THE INVENTION

### PROBLEM TO BE SOLVED BY THE INVENTION

The present invention is conceived after considering the above-described problems, and an object of which is to provide a film mirror for solar thermal power generation having the outermost layer which is less scratchable and less fouling after long-term use, light-weight, flexible, highly weatherable, and exhibiting a good regular reflectance to sunlight, and also to provide a method for producing the same, and a reflecting device for solar thermal power generation using the same.

### MEANS TO SOLVE THE PROBLEM

The problems to be addressed by the present invention may be solved by the configurations below.

1. A film mirror for solar thermal power generation comprising a reflective layer over a base and a hard coat layer at an outermost surface in which the outermost hard coat layer contains a fluorine atom-containing leveling agent in 0.1% by mass or more and 10% by mass or less relative to the solid resin content thereof.

2. The film mirror for solar thermal power generation of above 1 in which the outermost hard coat layer is formed by UV-curing of a UV curable resin which contains an acrylic monomer.

3. The film mirror for solar thermal power generation of above 1 or 2 in which the outermost hard coat layer contains at least one of a UV absorber composed of an organic compound and a UV absorber composed of an inorganic compound.

4. The film mirror for solar thermal power generation of above 3 in which the UV absorber composed of an organic compound is a triazine-based UV absorber and the UV absorber composed of an inorganic compound is at least any one of titanium oxide, zinc oxide, cerium oxide and iron oxide.

5. The film mirror for solar thermal power generation of any one of above 1 to 4 which further includes a layer containing an antioxidant on the base.

6. The film mirror for solar thermal power generation of any one of above 1 to 5 in which the fluorine atom-containing leveling agent is any one of polyacrylate-based polymer, polyvinyl ether-based polymer and silicone-based polymer, all of which are obtained by polymerizing a fluorine atom-containing monomer unit.

7. A method for producing a film mirror for solar thermal power generation of any one of above 1 to 6 which includes a step of forming the reflective layer by vacuum deposition of silver.

8. A reflecting device for solar thermal power generation including the film mirror for solar thermal power generation of any one of above 1 to 6 in which the film mirror for solar thermal power generation is bonded to a support body through a sticky layer.

### ADVANTAGEOUS EFFECTS OF THE INVENTION

The present invention succeeded in providing a film mirror for solar thermal power generation, capable of keeping high hardness and antifouling property of the outermost hard coat layer even after got wet in rain, washing or dewing, and capable of keeping high reflectance as a result of improved resistance against scratch and dirt.

### BRIEF DESCRIPTION OF THE DRAWINGS

[FIG 1] FIG 1 is a schematic cross sectional view illustrating an exemplary configuration of a film mirror for solar thermal power generation of the present invention.
[FIG. 2] FIG 2 is a schematic cross sectional view illustrating an exemplary configuration of a film mirror for solar thermal power generation of the present invention.

### DESCRIPTION OF EMBODIMENTS

The present inventors found out through our diligent investigations that the degradation in hardness observed after the water film is formed over the surface of the hard coat layer was mainly ascribable to lowering of the glass transition point of the hard coat layer induced by absorption of water molecule by the hard coat layer. It was also found that the water absorption by the hard coat layer was effectively suppressed when the hard coat layer contains 0.1% by mass or more and 10% by mass or less, relative to the solid resin content, of a fluorine atom-containing leveling agent, and the degradation in hardness due to lowered glass transition point became less likely to occur. It was also found that the surface of the hard coat layer became water-repellent by incorporating a fluorine-containing leveling agent, and became less likely to allow dirt to adhere thereon as originated by the water film after dewing or washing. It was also found that fluorine atom-containing groups contained in the leveling agent are aligned on the surface of the hard coat layer, and this made the outermost surface of the film mirror less frictional and suppressed thereon deposition of sand dust during the dry time.

The individual constituents of the film mirror for solar thermal power generation will be detailed below.

### (Constituents of Film Mirror for Solar Thermal Generation)

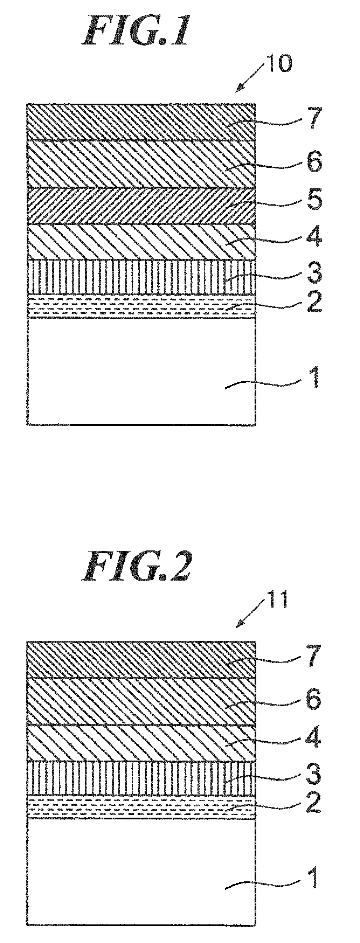

The constituents of the film mirror for solar thermal power generation of the present invention will be explained referring to FIG 1 and FIG 2.

Each of film mirrors for solar thermal power generation (10,11) has at least, as the constituents thereof, a reflective layer 3, and a hard coat layer 7 which composes the outermost layer on the top side, wherein the hard coat layer 7 configures the outermost layer having both of water repellency and scratch-proof property.
More specifically, preferable embodiments relate to the film mirror for solar thermal power generation 10 illustrated in FIG 1, additionally having an anchor layer 2, an anticorrosive layer 4, an adhesive layer 5, and a translucent resin layer 6, and the film mirror for solar thermal power generation 11 illustrated in FIG 2, additionally having the anchor layer 2, the anticorrosive layer 4, and the translucent resin layer 6.

### [Hard Coat Layer]

The film mirror for solar thermal power generation of the present invention has provided thereto the hard coat layer as the outermost layer. The hard coat layer in the present invention is provided for the purpose of scratch prevention and dirt prevention.

The hard coat layer in the present invention is preferably formed by using, for example, acrylic resin, urethane-based resin, melamine-based resin, epoxy-based resin, organosilicate compound, or silicone-based resin, by UV curing or heat curing. In particular in the present invention, UV curing is preferably adopted in view of keeping planarity of a lower resin base. In particular, it is also preferable to use acrylic resin in view of hardness and durability. UV-curable acrylic resin is a compound which contains, as a polymerizable and curable component, multifunctional acrylate, acrylic oligomer or reactive diluent. Also those optionally containing a photo-initiator, photo-sensitizer, thermal polymerization initiator or modifier may be used.

The UV-curable resin is exemplified by (meth)acrylate-based resin such as those containing trimethylolpropane tri(meth)acrylate, trimethylolpropane tris(hydroxyethyl (meth)acrylate), tris(2-hydroxyethyl)isocyanurate tri(meth)acrylate, pentaerythritol tri(meth)acrylate, pentaerythritol tetra(meth)acrylate, dipentaerythritol hexa(meth)acrylate, or multifunctional urethanized (meth)acrylate as a major component. The multifunctional urethanized (meth)acrylate herein means a compound having in the molecule thereof a urethane bond and at least two (meth)acryloyl groups, obtained by an addition reaction to allow, for example, polyisocyanate having at least two ixocyanatato groups (-NCO) such as isophorone diisocyanate and hexamethylene diisocyanate, to react with a compound having in the molecule thereof one hydroxy group and at least one (meth)acryloyl group such as trimethylolpropane di(meth)acrylate and pentaerythritol tri(meth)acrylate. These UV-curable resins may be used independently, or in the form of mixture of two or more species. Alternatively, the multifunctional urethanized (meth)acrylate may be used in combination with the above-described multifunctional (meth)acrylate having no urethane bond.

The UV-curable resin preferably used herein may be selected from those commercially available. Specific examples of commercially available products of the UV-curable resin include Kayarad DPHA (from Nippon Kayaku Co. Ltd.), Kayarad DPCA-20 (from Nippon Kayaku Co. Ltd.), Kayarad DPCA-30 (from Nippon Kayaku Co. Ltd.), Kayarad DPCA-60 (from Nippon Kayaku Co. Ltd.), Kayarad DPCA-120 (from Nippon Kayaku Co. Ltd.), Kayarad D-310 (from Nippon Kayaku Co. Ltd.), Kayarad D-330 (from Nippon Kayaku Co. Ltd.), Kayarad PET-30 (from Nippon Kayaku Co. Ltd.), Kayarad GPO-303 (from Nippon Kayaku Co. Ltd.), Kayarad TMPTA(from Nippon Kayaku Co. Ltd.), Kayarad THE-330 (from Nippon Kayaku Co. Ltd.), Kayarad TPA-330 (from Nippon Kayaku Co. Ltd.), Aronix M-315 (from Toagosei Co. Ltd.), and Aronix M-325 (from Toagosei Co. Ltd.).

The above-described UV-curable resin is generally used in the form of mixture with a photopolymerization initiator. Examples of the photopolymerization initiator preferably used herein include commercially available products such as Irgacure 907 (from Chiba Japan Ltd.), Irgacure 184 (from Ciba Japan Ltd.), and Lucirin TPO (from BASF GmbH).

From the viewpoint of obtaining a hard coat layer having a sufficient level of hardness, and capable of sufficiently suppressing curling due to setting shrinkage, silica fine particle may be added to the UV curable resin. The silica fine particle preferably used in this case is exemplified by powdery silica and colloidal silica, with an average particle size of 0.01 to 20 µm. The silica fine particle is preferably not affective to translucency of the hard coat film, and therefore preferably has a primary particle size of 10 to 350 nm, and more preferably 10 to 50 nm. The above-described average particle size of silica fine particle is measurable, for example, by observation under a transmission electron microscope, and the primary particle size of silica particle is measurable, for example, by using a dispersion of the particle in a solvent such as isopropanol, by Coulter particle size distribution analysis, laser diffraction and scattering method, and dynamic light scattering method. Among them, the Coulter particle size distribution analysis is generally adopted.

While geometry of the silica fine particle may be spherical, hollow, porous, rod-like, plate-like, fibrous, or undefined, it is preferably spherical in view of thoroughly dispersing the particle in the UV-curable resin without causing coagulation of particle. From the viewpoint of ensuring hardness and planarity of the hard coat layer 3, the specific surface area of the silica fine particle preferably falls in the range from 0.1 to 3000 m²/g, more preferably 1 m²/g or larger, particularly 10 m²/g or larger, and 1500 m²/g or smaller.

Also the silica fine particle is preferably selectable from those commercially available. Examples of marketed product of colloidal silica include methanol silica sol (from Nissan Chemical Industries, Ltd.), IPA-ST (from Nissan Chemical Industries, Ltd.), MEK-ST (from Nissan Chemical Industries, Ltd.), NBA-ST (from Nissan Chemical Industries, Ltd.), XBA-ST (from Nissan Chemical Industries, Ltd.), DMAC-ST (from Nissan Chemical Industries, Ltd.), ST-UP (from Nissan Chemical Industries, Ltd.), ST-OUP (from Nissan Chemical Industries, Ltd.), ST-20 (from Nissan Chemical Industries, Ltd.), ST-40 (from Nissan Chemical Industries, Ltd.), ST-C (from Nissan Chemical Industries, Ltd.), ST-N (from Nissan Chemical Industries, Ltd.), ST-O (from Nissan Chemical Industries, Ltd.), ST-50 (from Nissan Chemical Industries, Ltd.), and ST-OL (from Nissan Chemical Industries, Ltd.). Examples of marketed product of powdery silica include Aerosil 130 (from Nippon Aerosil Co. Ltd.), Aerosil 300 (from Nippon Aerosil Co. Ltd.), Aerosil 380 (from Nippon Aerosil Co. Ltd.), Aerosil TT600 (from NipponAerosil Co. Ltd.), Aerosil OX50 (from Nippon Aerosil Co. Ltd.), Sildex H31 (from Asahi Glass Co. Ltd.), Sildex H32 (from Asahi Glass Co. Ltd.), Sildex H51 (from Asahi Glass Co. Ltd.), Sildex H52 (from Asahi Glass Co. Ltd.), Sildex H121 (from Asahi Glass Co. Ltd.), Sildex H122 (from Asahi Glass Co. Ltd.), E220A (from Nippon Silica Industrial Ltd.), E220 (from Nippon Silica Industrial Ltd.), Sylysia 470 (from Fuji Silysia Chemical Ltd.), and SG flake (from Nippon Sheet Glass Co. Ltd).

### <Leveling Agent>

In the present invention, the curable resin composition used for forming the hard coat layer is added with a leveling agent, in order to ensure a good surface smoothness of the resultant hard coat layer. The leveling agent is a chemical capable of reducing surface tension of a coating material when added thereto, and of improving surface smoothness of a paint film to be obtained.

While substances generally used as the leveling agent include polyacrylate-based polymer such as polyalkyl acrylate; polyvinyl ether-based polymer such as polyalkyl vinyl ether; and silicone-based polymer such as dimethylpolysiloxane, methylphenylpolysiloxane, and organic modified polysiloxane introduced with polyether, polyester, aralkyl and so forth, the leveling agent usable in the present invention is a sort of polymer additionally containing fluorine atoms. The fluorine atom-containing leveling agent may be obtained typically by allowing a fluorine-containing monomer to co- polymerize.

Specific products on the market include Surflon "S-381", "S-382", "SC-101" "SC-102", "SC-103", "SC-104" (all from Asahi Glass Co. Ltd.), Fluorad "FC-430", "FC-431", "FC-173"(all from Fluorochemicals-Sumitomo 3M Ltd.), Eftop "EF352", "EF301", "EF303" (all from Shin-Akita Kasei Co. Ltd.), Schwego Fluor "8035", "8036" (both from Schwegmann), 'BM1000", "BM1100" (both from BM Chemie), Megafac "F-171", "F-470", "RS-75", "RS-72-K" (all from DIC Corporation), BYK340 (from BYK Chemie Japan), and "ZX-049", "ZX-001", "ZX-017" (all from Fuji Kasei Kogyo Co. Ltd.).

In the present invention, 0.1% by mass or more and 10% by mass or less, relative to the solid resin content in the outermost hard coat layer, of the fluorine atom-containing leveling agent is contained in the outermost hard coat layer. The leveling agent may be mixed into a curable resin composition, so as to adjust the content thereof to 0.1% by mass or more and 10% by mass or less relative to the solid content of curable resin. If the content of the leveling agent in the curable resin composition is smaller than 0.1% by mass of the solid content of UV-curable resin, the hard coat layer will unfortunately be insufficient in the water repellency, and will therefore be covered with water film during rainfall, dewing or washing, lowered in Tg due to absorption of water, becomes more scratchable, and insufficient in autifouling property. On the other hand, the content of leveling agent in the curable resin composition, exceeding 10% by mass of the solid content of UV-curable resin, is also inadequate since a sufficient level of hardness will not be achieved. Preferable content of the leveling agent is therefore 0.5% by mass or more and 5% by mass or less of the solid resin content of the outermost hard coat layer. In this case, the scratch-proof property and the antifouling property will further be improved.

The hard coat layer in the present invention may be formed by coating a coating liquid which contains the above-described curable resin composition composed of the UV-curable resin and the leveling agent, and additionally a UV absorber and an antioxidant, onto the resin base, and by irradiating UV light so as to cure the curable resin composition, to thereby form on the resin base the hard coat layer which is a cured product of the curable resin composition.

In the present invention, the coating liquid used for forming the hard coat layer may be obtained by diluting the ionizing radiation-curable resin so as to adjust the solid content to 30 to 70% by mass, using at least one species of ethyl acetate, methyl ethyl ketone, methyl isobutyl ketone, and cyclohexanone as a solvent If the content of the ionizing radiation-curable resin in the coating liquid is smaller than 30% by mass, the solvent concentration will be too dense and will be difficult to form a coated film of 10 to 30 µm thick when coated over the resin base. On the other hand, if the content of the ionizing radiation-curable resin in the coating liquid exceeds 70% by mass, the coating liquid will be too viscous and will make the coated film non-uniform to thereby impair the planarity.

### <UV absorber>

In the present invention, the curable resin composition used for forming the hard coat layer preferably contains an UV absorber composed of an organic compound, or a UV absorber composed of an inorganic compound, or the both, for the purpose of improving the weatherability of the resultant hard coat layer and the lower resin layer. The organic compound, if chosen, is preferably a triazine-based UV absorber.

### <Inorganic UV Absorber>

The inorganic UV absorber used in the present invention is principally a metal oxide-based pigment characterized in that when it is dispersed in an acrylic resin so as to adjust the concentration to 20% by mass or more and a film of 6 µm thick is formed, the films shows a transmissivity of light in the UV-B region (290-320 nm) of 10% or less. It is particularly preferable to select the inorganic UV absorber usable in the present invention from titanium oxide, zinc oxide, iron oxide, cerium oxide or mixtures of them.

From the viewpoint of improving the translucency of the layer containing the inorganic UV absorber, the inorganic UV absorber is preferably selected from those having an average basic particle size of 5 nm to 500 nm, and particularly from those having an average particle size of 10 nm to 100 nm and a maximum particle size in the particle size distribution of 150 nm or below. This sort of coated and non-coated metal oxide pigments are detailed in EP-A-0 518 773.

In the present invention, from the viewpoint of oxidation degradation of the adjacent resin due to photocatalytic action of the inorganic oxide, the inorganic UV absorber, as coated, preferably has an average particle size of 10 nm or larger and 100 nm or smaller. The surface coating is preferable also because it can improve dispersibility of the inorganic UV absorber particles. The coated inorganic UV absorber herein means inorganic UV absorber treated on the surface thereof with a compound selected from amino acid, beeswax, fatty acid, aliphatic alcohol, anionic surfactant, lecithin, sodium salt, potassium salt, zinc salt, iron salt or aluminum salt of fatty acid, metal alkoxide (of titanium or aluminum), polyethylene, silicone, protein (collagen, elastin), alkanolamine, silicon oxide, metal oxide and sodium hexametaphosphate, by any one of, or combination of two or more means selected from chemical, electronic, mechanochemical, and mechanical means.

Amount of the inorganic UV absorber, when used independently, is adjusted to 1 to 30% by mass of the total mass of the UV absorbing layer, preferably to 5 to 25% by mass, and more preferably 15 to 20% by mass. The content exceeding 30% by mass will degrade the bonding strength, and the content less than 1% by mass will improve the weatherability only to a limited degree.

Amount of the inorganic UV absorber, when combined with an organic UV absorber described later, is adjusted to 3 to 20% by mass of the total mass of the UV absorbing layer, preferably to 5 to 10% by mass, whereas amount of use of the organic UV absorber is 0.1 to 10% by mass, and preferably 0.5 to 5% by mass. By using the inorganic UV absorber and the organic UV absorber in combination within the above-described ranges of content, the UV absorbing layer will be improved in the translucency and weatherability.

### <Triazine-Based UV Absorber>

Triazine-based UV absorber preferably used in the present invention is represented by the general formula (I) below.

General formula (I) Q¹-Q²-OH

In the formula, Q1 represents a 1,3,5-triazine ring, and Q2 represents an aromatic ring.

The formula (I) is more preferably represented by the general formula (I-A) below.

[Chemical Formula 1]

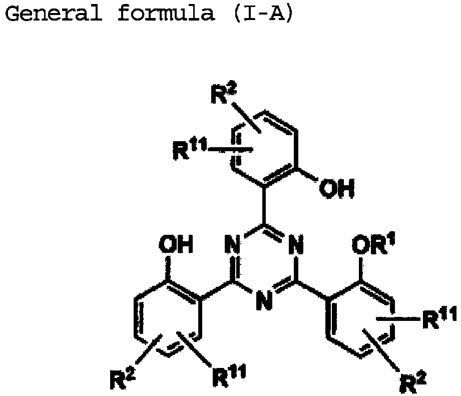

In the formula, R¹ represents a C₁₋₁₈ alkyl group; C₅₋₁₂ cycloalkyl group; C₃₋₁₈ alkenyl group; phenyl group; C₁₋₁₈ alkyl group substituted by a phenyl group, hydroxy group, C₁₋₁₈ alkoxy group, C₅₋₁₂ cycloalkoxy group, C₃₋₁₈ alkenyloxy group, halogen atom, -COOH, -COOR⁴, -O-CO-R⁵, -O-CO-O-R⁶, -CO-NH₂, -CO-NHR⁷, -CO-N(R⁷)(R⁸), CN, NH₂, NHR⁷, -N(R⁷)(R⁸), NH-CO-R⁵, phenoxy group, phenoxy group substituted by a C₁₋₁₈ alkyl group, phenyl-C₁₋₄ alkoxy group, C₆₋₁₅ bicycloalkoxy group, C₆₋₁₅ bicycloalkylalkoxy group, C₆₋₁₅ bicycloalkenylalkoxy group, or C₆₋₁₅ tricycloalkoxy group; C₅₋₁₂ cycloalkyl group substituted by a hydroxy group, C₁₋₄ alkyl group, C₂₋₆ alkenyl group or -O-CO-R⁵; glycidyl group; -CO-R⁹ or -SO₂-R¹⁰; or R¹ represents a C₃₋₅₀ alkyl group discontinued by one or more oxygen atoms and/or substituted by a hydroxy group, phenoxy group or C₇₋₁₈ alkylphenoxy group; or R¹ represents any one of -A; -CH₂-CH(XA)-CH₂-O-R¹²; -CR¹³R'¹³-(CH₂)ₘ-X-A; -CH₂-CH(OA)-R¹⁴; -CH₂-CH(OH)-CH₂-XA;

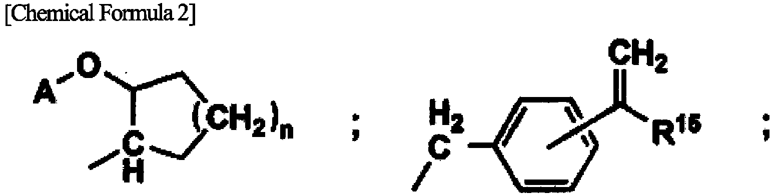

-CR¹⁵R'¹⁵-C(=CH₂)-R"¹⁵; -CR¹³R'¹³-(CH₂)ₘ-CO-X-A; -CR¹³R'¹³-(CH₂)ₘ-CO-O-CR¹⁵R_{'}¹⁵-C(=CH₂)-R"¹⁵ and -CO-O-CR¹⁵R'¹⁵-C(=CH₂)-R"¹⁵ (in the formulae, A represents -CO-CR¹⁶=CH-R¹⁷).

Each R² independently represents a C₆₋₁₈ alkyl group; C₂₋₆ alkenyl group; phenyl group; C₇₋₁₁ phenylalkyl group; COOR⁴; CN; NH-CO-R⁵; halogen atom; trifluoromethyl group; or -O-R³.

R³ is same as R¹; R⁴ represents a C₁₋₁₈ alkyl group; C₃₋₁₈ alkenyl group; phenyl group; C₇₋₁₁ phenylalkyl group; C₅₋₁₂ cycloalkyl group; or R⁴ represents a C₃₋₅₀ alkyl group discontinued by one or more -O-, -NH-, -NR⁷-, -S-, and may be substituted by OH, phenoxy group or C₇₋₁₈ alkylphenoxy group; R⁵ represents H; C₁₋₁₈ alkyl group; C₂₋₁₈ alkenyl group; C₅₋₁₂ cycloalkyl group; phenyl group; C₇₋₁₁ phenylalkyl group; C₆₋₁₅ bicycloalkyl group; C₆₋₁₅ bicycloalkenyl group; C₆₋₁₅ tricycloalkyl group; R⁶ represents H; C₁₋₁₈ alkyl group; C₃₋₁₈ alkenyl group; phenyl group; C₇₋₁₁ phenylalkyl group; C₅₋₁₂ cycloalkyl group; each of R⁷ and R⁸ independently represents a C₁₋₁₂ alkyl group; C₃₋₁₂ alkoxyalkyl group; C₄₋₁₆ dialkylaminoalkyl group; or C₅₋₁₂ cycloalkyl group; or both of R⁷ and R⁸ represent C₃₋₉ alkylene group, C₃₋₉ oxaalkylene group or C₃₋₉ azaalkylene group; R⁹ represents a C₁₋₁₈ alkyl group; C₂₋₁₈ alkenyl group; phenyl group; C₅₋₁₂ cycloalkyl group; C₇₋₁₁ phenyl alkyl group; C₆₋₁₅ bicycloalkyl group; C₆₋₁₅ bicycloalkylalkyl group, C₆₋₁₅ bicycloalkenyl group; or C₆₋₁₅ tricycloalkyl group; R¹⁰ represents a C₁₋₁₂ alkyl group; phenyl group; naphthyl group; or C₇₋₁₄ alkylphenyl group; each R¹¹ independently represents H; C₁₋₁₈ alkyl group; C₃₋₆ alkenyl group; phenyl group; C₇₋₁₁ phenylalkyl group; halogen atom; C₁₋₁₈ alkoxy group; R¹² represents a C₁₋₁₈ alkyl group; C₃₋₁₈ alkenyl group; phenyl group; C₁₋₈ alkyl group, C₁₋₈ alkoxy group, C₃₋₈ alkenoxy group, halogen atom or phenyl group substituted once to three times by trifluoromethyl groups; or C₇₋₁₁ phenylalkyl group; C₅₋₁₂ cycloalkyl group; C₆₋₁₅ tricycloalkyl group; C₆₋₁₅ bicycloalkyl group; C₆₋₁₅ bicycloalkylalkyl group; C₆₋₁₅ bicycloalkenylalkyl group; -CO-R⁵; or R¹² represents a C₃₋₅₀ alkyl group discontinued by one or more -O-, -NH-, -NR⁷-, -S-, and may be substituted by OH, phenoxy group or C₇₋₁₈ alkylphenoxy group; each of R¹³ and R'¹³ independently represents H; C₁₋₁₈ alkyl group; phenyl group; R¹⁴ represents a C₁₋₁₈ alkyl group; C₃₋₁₂ alkoxyalkyl group; phenyl group; phenyl-C₁₋₄ alkyl group; each of R¹⁵, R"¹⁵ and R"¹⁵ independently represents H or CH₃; R¹⁶ represents H; -CH₂-COO-R⁴; C₁₋₄ alkyl group; or CN; R¹⁷ represents H; -COOR⁴; C₁₋₁₇ alkyl group; or phenyl group; X represents -NH-; -NR⁷-; -O-; -NH-(CH₂)ₚ-NH-; or -O-(CH₂)_{q}-NH-; and numeral m represents 0 to 19; numeral n represents 1 to 8; numeral p represents 0 to 4; and numeral q represents 2 to 4; where in the general formula (I-A), at least one of R¹, R² and R¹¹ contains two or more carbon atoms.

### <Antioxidant>

An antioxidant is preferably used for the hard coat layer. By using the antioxidant, the weatherability may be improved. It is effective to use the antioxidant for the outermost layer.

The antioxidant usable in the present invention may be selected from the group consisting of hindered phenolic compound, hindered amine-based compound, and phosphorus-containing compound.

Specific examples of the hindered phenolic compound include *n*-octadecyl-3-(3,5-di-*t*-butyl-4-hydroxyphenyl)-propionate, *n-oc*tadecyl-3-(3,5-di-*t*-butyl-4-hydroxyphenyl) acetate, *n*-octadecyl-3,5-di-*t*-butyl-4-hydroxybenzoate, *n*-hexyl-3,5-di-*t*-butyl-4-hydroxyphenylbenzoate, *n*-dodecyl-3,5-di-*t*-butyl-4-hydroxyphenylbenzoate, neo-dodecyl-3-(3,5-di-*t*-butyl-4-hydroxyphenyl)propionate, dodecyl-β-(3,5-di-*t*-butyl-4-hydroxyphenyl) propionate, ethyl-α-(4-hydroxy-3,5-di-*t*-butylphenyl) isobutylate, octadecyl-α-(4-hydroxy-3,5-di-*t*-butylphenyl) isobutylate, octadecyl-α-(4-hydroxy-3,5-di-*t*-butyl-4-hydroxyphenyl) propionate, 2-(*n*-octylthio)ethyl-3,5-di-*t*-butyl-4-hydroxy-benzoate, 2-(*n*-octylthio)ethyl-3,5-di-*t*-butyl-4-hydroxyphenyl acetate, 2-(*n*-octadecyl-thio)ethyl-3,5-di-*t*-butyl-4-hydroxyphenyl acetate, 2-(*n*-octadecyl-thio)ethyl-3,5-di-*t*-butyl-4-hydroxy-benzoate, 2-(2-hydroxyethyl-thio)ethyl-3,5-di-*t*-butyl-4-hydroxybenzoate, diethyl-glycolbis-(3,5-di-*t*-butyl-4-hydroxy-phenyl)propionate, 2-(*n*-octadecyl-thio)ethyl-3-(3,5-di-*t*-butyl-4-hydroxyphenyl)propionate, stearylamide N,N-bis-[ethylene-3-(3,5-di-*t*-butyl-4-hydroxyphenyl) propionate], *n*-butylimino-N,N-bis-[ethylene-3-(3,5-di-*t*-butyl-4-hydroxyphenyl)propionate], 2-(2-stearoyloxyethyl-thio)ethyl-3,5-di-*t*-butyl-4-hydroxybenzoate, 2-(2-stearoyloxyethylthio)ethyl-7-(3-methyl-5-*t*-butyl-4-hydroxyphenyl) heptanoate, 1,2 propylene glycol bis-[3-(3,5-di-*t*-butyl-4-hydroxy phenyl)propionate], ethylene glycol bis-[3-(3,5-di-*t*-butyl-4-hydroxyphenyl) propionate], neopentyl glycol bis-[3-(3,5-di-*t*-butyl-4-hydroxyphenyl) propionate], ethylene glycol bis-(3,5-di-*t*-butyl-4-hydroxyphenyl acetate), glycerin-1-*n*-octadecanoate-2,3-bis-(3,5-di-*t*-butyl-4-hydroxyphenyl acetate), pentaerythritol tetrakis-[3-(3',5'-di-*t*-butyl-4'-hydroxyphenyl) propionate], 3,9-bis-{2-[3-(3-*tert*-butyl-4-hydroxy-5-methylphenyl) propionyloxy]-1,1-dimethylethyl}-2,4,8,10-tetraoxaspiro[5.5] undecane, 1,1,1-trimethylolethane-tris[3-(3,5-di-*t*-butyl-4-hydroxyphenyl) propionate], sorbitol hexa[3-(3,5-di-*t*-butyl-4-hydroxyphenyl)propionate], 2-hydroxyethyl-7-(3-methyl-5-*t*-butyl-4-hydroxyphenyl) propionate, 2-stearoyloxyethyl-7-(3-methyl-5-*t*-butyl-4-hydroxyphenyl) heptanoate, 1,6-*n*-hexanediol-bis[(3',5'-di-*t*-butyl-4-hydroxyphenyl) propionate], and pentaerythritol tetrakis (3,5-di-*t*-butyl-4-hydroxy-hydrocinnamate). The phenolic compounds of these types are marketed, for example, under the trade name of "IRGANOX 1076" and "IRGANOX1010" from Ciba Japan Ltd.

Specific examples of the hindered amine-based compound include bis(2,2,6,6-tetramethyl-4-piperidyl) sebacate, bis(2,2,6,6-tetramethyl-4-piperidyl) succinate, bis(1,2,2,6,6-pentamethyl-4-piperidyl) sebacate, bis(N-octoxy-2,2,6,6-tetramethyl-4-piperidyl) sebacate, bis(N-benzyloxy-2,2,6,6-tetramethyl-4-piperidyl) sebacate, bis(N-cyclohexyloxy-2,2,6,6-tetramethyl-4-piperidyl) sebacate, bis(1,2,2,6,6-pentamethyl-4-piperidyl)2-(3,5-di-*t*-butyl-4-hydroxybenzyl)-2 butyl malonate, bis(1-acryloyl-2,2,6,6-tetramethyl-4-piperidyl)-2,2-bis(3,5-di-t-butyl-4-hydroxybenzyl)-2-butyl malonate, bis(1,2,2,6,6-pentamethyl-4-piperidyl) decanedioate, 2,2,6,6-tetramethyl-4-piperidyl methacrylate, 4-[3-(3,5-di-t-butyl-4-hydroxyphenyl)propionyloxy]-1-[2-(3-(3,5-di-*t*-butyl-4-hydroxyphenyl)propionyloxy)eth yl-]-2,2,6,6-tetramethylpiperidine, 2-methyl-2-(2,2,6,6-tetramethyl-4-piperidyl)amino-N-(2,2,6,6-tetramethyl-4-piperidyl)propionamide, tetrakis(2,2,6,6-tetramethyl-4-piperidyl)1,2,3,4-butane tetracarboxylate, and tetrakis(1,2,2,6,6-pentamethyl-4-piperidyl)1,2,3,4-butane tetracarboxylate.

Also polymer-type compounds may be used, specific examples of which include high molecular weight HALS configured by a plurality of piperidine rings bound to a triazine skeleton, such as N,N',N",N'"-tetrakis[4,6-bis[butyl-(N-methyl-2,2,6,6-tetramethylpiperidine-4-yl)amino]-triazine-2-yl]-4,7-diazadecane-1,10-diamine, polycondensate of dibutylamine and 1,3,5-triazine-N,N'-bis(2,2,6,6-tetramethyl-4-piperidyl)-1,6-hexamethylenediamine and N-(2,2,6,6-tetramethyl-4-piperidyl)butylamine, polycondensate of dibutylamine and 1,3,5-triazine and N,N'-bis(2,2,6,6-tetramethyl-4-piperidyl)butyl amine, poly[{(1,1,3,3-tetramethylbutyl)amino-1,3,5-triazine-2,4-diyl} {(2,2,6,6-tetramethyl-4-piperidyl)imino}hexamet hylene{(2,2,6,6-tetramethyl-4-piperidyl)imino}], polycondensate of 1,6-hexanediamine-N,N'-bis(2,2,6,6-tetramethyl-4-piperidyl) and morpholine-2,4,6-trichloro-1,3,5-triazine, and poly[(6-morpholino-*s*-triazine-2,4-diyl)[(2,2,6,6,-tetramethyl-4-piperidyl)imino]-hexamethylene[(2,2,6,6-tetram ethyl-4-piperidyl)imino]]; and compounds configured by a plurality of piperidine rings bound by ester bonds, such as polymer of dimethyl succinate and 4-hydroxy-2,2,6,6-tetramethyl-1-piperidine ethanol, and mixed estrified product of 1,2,3,4-butanetetracarboxylic acid and 1,2,2,6,6-pentamethyl-4-piperidinol and 3,9-bis(2-hydroxy-1,1-dimethylethyl-)-2,4,8,10-tetraoxaspiro[5,5]undecane, but not limited thereto.

Among them, polycondensate of dibutylamine and 1,3,5-triazine and N,N'-bis(2,2,6,6-tetramethyl-4-piperidyl)butylamine, poly[{(1,1,3,3-tetramethylbutyl)amino-1,3,5-triazine-2,4-diyl}{(2,2,6,6-tetramethyl-4-piperidyl)imino}hexamet hylene{(2,2,6,6-tetramethyl-4-piperidyl)imino}], and polymer of dimethyl succinate and 4-hydroxy-2,2,6,6-tetramethyl-1-piperidine ethanol, each having a number average molecular weight (Mn) of 2,000 to 5,000, are preferably used.

The hindered amine compounds of the above-described types are marketed, for example, under the trade names of "TINUVIN144" and "TINUVIN770" from Ciba Japan Ltd., and under the trade name of "ADK STAB LA-52" from ADEKA Corporation.

Specific examples of the phosphorus-containing compound include mono phosphite-based compounds such as triphenyl phosphite, diphenylisodecyl phosphite, phenyldiisodecyl phosphite, tris(nonylphenyl) phosphite, tris(dinonylphenyl) phosphite, tris(2,4-di-*t*-butylphenyl) phosphite, 10-(3,5-di-*t-*butyl-4-hydroxybenzyl)-9,10-dihydro-9-oxa-10-phosphaphenanthrene-10-oxide, 6-[3-(3-*t*-butyl-4-hydroxy-5-methylphenyl)propoxy]-2,4,8,10-tetra-*t*-butyldibenz[d,f][1,3,2]dioxaphosphepin, and tridecyl phosphite; diphosphite-based compounds such as 4,4'-butylidene-bis(3-methyl-6-*t*-butylphenyl-di-tridecyl phosphite), and 4,4'-isopropylidene-bis(phenyl-di-alkyl(C₁₂₋₁₅) phosphite); phosphonite-based compounds such as triphenylphosphonite, tetrakis (2,4-di-*tert*-butylphenyl)[1,1-biphenyl]4,4'-diyl bisphosphonite, and tetrakis(2,4-di-*tert*-butyl-5-methylphenyl)[1,1-biphenyl]-4,4'-diylbisphosphonite; phosphinite-based compounds such as triphenyl phosphinite, and 2,6-dimethyl phenyldiphenyl phosphinite; and phosphine-based compounds such as triphenyl phosphine, and tris(2,6-dimethoxyphenyl) phosphine.

The phosphorus-containing compounds of these types are commercially available, for example, from Sumitomo Chemical Co. Ltd. under the trade name of "Sumilizer GP", from ADEKA Corporation under the trade names of"ADK STAB PEP-24G", "ADK STAB PEP-36" and "ADK STAB 3010", from Ciba Japan Ltd. under the trade name of "IRGAFOS P-EPQ", and from Sakai Chemical Industry Co. Ltd. under the trade name of "GSY-P101".

### [Anchor Layer]

The anchor layer formed in the reflective film of the present invention is composed of a resin, and acts to tightly bond the plastic film and the reflective layer described later. Accordingly, it is necessary for the anchor layer to show a bonding strength enough to tightly bond the plastic film and the reflective layer, heat resistance enough to endure heat in the process of forming the reflective layer typically by vacuum deposition, and smoothness enough to ensure an excellent reflective performance intrinsic to the reflective layer.

The resin used for the anchor layer is not specifically limited so long as it satisfies the above-described conditions for bonding strength, heat resistance, and smoothness, and is exemplified by polyester-based resin, acrylic resin, melamine-based resin, epoxy-based resin, polyamide-based resin, vinyl chloride-based resin, vinyl chloride vinyl acetate copolymer-based resin, which may be used independently, or in the form of mixed resin. From the viewpoint of weatherability, a mixed resin of polyester-based resin and melamine-based resin is preferable, and a thermosetting resin additionally mixed with a curing agent such as isocyanate is more preferable.

Thickness of the anchor layer is preferably 0.01 to 3 µm, and more preferably 0.1 to 1 µm.

When the thickness is adjusted to the above-described ranges, the bonding strength is improved, proving a large effect of formation of the anchor layer, surface irregularity of the plastic film may be concealed, the smoothness is improved, and the reflectance of the reflective film increases as a consequence. The bonding strength is not expectable if the thickness is adjusted to exceed 3 µm, and may even degrade the smoothness due to non-uniformity in coating.

Available methods of forming the anchor layer include gravure coating, reverse coating, die coating, and any other publicly known methods of coating.

### [Translucent Resin Layer]

The translucent resin layer is a resin layer composed of a translucent resin material which contains a UV absorber.
Resin materials for composing the translucent resin layer are not specifically limited, so that various publicly known synthetic resins, capable of keeping translucency after formed into thin film, may be used. Examples of the resin materials include polyester such as polyethylene terephtalate (PET), and polyethylene naphthalate (PEN), polyethylene, polypropylene, cellulose ester or derivative thereof such as cellophane, cellulose diacetate, cellulose triacetate (TAC), cellulose acetate butyrate, cellulose acetate propionate (CAP), cellulose acetate phthalate, and cellulose nitrate, polyvinilydene chloride, polyvinyl alcohol, polyethylene vinyl alcohol, syndiotactic polystyrene, polycarbonate, norbornene resin, polymethylpentene, polyether ketone, polyimide, polyethersulfone (PES), polysulfones, polyetherketone imide, polyamide, fluorine-containing resin, nylon, polymethyl methacrylate, acryl or polyallylates, and cycloolefin resin such as Arton (trade name, from JSR Corporation) andApel (trade name, from Mitsui Chemicals, Inc.).

Methods of forming the translucent resin layer are exemplified by melt casting, extrusion molding, and coating.
The translucent resin layer manufactured by melt casting or extrusion molding may be any of publicly known resin film on the market.
For the case where a coating film, aimed to be the translucent resin layer, is formed by coating, any of various methods of coating having been used conventionally, such as spray coating, spin coating, or bar coating may be used. The translucent resin layer may be formed by coating a material for forming the translucent resin layer, directly over the surface of the reflective layer on the light-incident side thereof, or over a constitutive layer provided on the light-incident side of the reflective layer (for example, the anticorrosive layer).
By forming the translucent resin layer by the coating method described in the above, the translucent resin layer may be improved in the smoothness. More specifically, the translucent resin layer formed by the coating method may be adjusted to a center line average roughness (Ra) of 3 nm or larger and 20 nm or smaller. In other words, if the center line average roughness satisfies the value, the translucent resin layer may be assumed as provided by coating, rather than by bonding a translucent resin film manufactured by melt casting using an adhesive layer.
Thickness of the translucent resin layer is preferably 10 to 150 µm, more preferably 20 to 100 µm, and still more preferably 40 to 100 µm.
The center line average roughness (Ra) which gives an index of smoothness of the translucent resin layer may be determined by a method conforming to JIS B0601-1982.

Of the resin materials exemplified in the above as those composing the translucent resin layer, acryl is preferably used.
Since the acryl resin is hard, the acryl, when used for forming the translucent resin layer, may contain a plasticizer particle in order to make the acrylic translucent resin layer flexible and less fracturable. Preferable examples of the plasticizer include butyl rubber and butyl acrylate.

The acrylic translucent resin layer preferably contains a methacrylic resin as a major component. The methacrylic resin is a polymer mainly composed of methacrylate ester, which may be a homopolymer of methacrylic ester, or may be a copolymer composed of 50% by weight or more of methacrylic ester and 50% by weight or less of other monomer. The methacrylate ester used herein is generally an alkyl ester of methacrylic acid. In particular, poly methyl methacrylate resin (PMMA) is a preferable methacrylic resin.

A preferable monomer composition of the methacrylic resin, on the basis of the total monomer, is such as containing 50 to 100% by weight of methacrylate ester, 0 to 50% by weight of acrylate ester, and 0 to 49% by weight of other monomer, wherein a more preferable composition is such as containing 50 to 99.9% by weight of methacrylate ester, 0.1 to 50% by weight of acrylate ester, and 0 to 49% by weight of other monomer.

Specific examples of the alkyl methacrylate include methyl methacrylate, ethyl methacrylate, butyl methacrylate, and 2-ethylhexyl methacrylate, wherein the number of carbon atoms in the alkyl group is generally 1 to 8, and preferably 1 to 4. Among them, methyl methacrylate is preferably used.

Specific examples of the alkyl acrylate include methyl acrylate, ethyl acrylate, butyl acrylate, and 2-ethylhexyl acrylate, wherein the number of carbon atoms in the alkyl group is generally 1 to 8, and preferably 1 to 4.

The monomer other than alkyl methacrylate and alkyl acrylate may be a monofunctional monomer which means a compound having in the molecule thereof one polymerizable carbon-carbon double bond, or may be a multifunctional monomer which means a compound having in the molecule thereof at least two polymerizable carbon-carbon double bonds, wherein the monofunctional monomer is preferably used Examples of the monofunctional monomer include aromatic alkenyl compound such as styrene, α-methylstyrene, vinyltoluene, and alkenyl cyan compound such as acrylonitrile, and methacrylonitrile. Examples of the multifunctional monomer include polyunsaturated carboxylic ester of polyhydric alcohol such as ethylene glycol dimethacrylate, butanediol dimethacrylate, and trimethylolpropane triacrylate; alkenyl ester of unsaturated carboxylic acid such as allyl acrylate, allyl methacrylate, and allyl cinnamate; polyalkenyl ester of polybasic acid such as diallyl phthalate, diallyl maleate, triallyl cyanurate, and triallyl isocyanurate; and aromatic polyalkenyl compound such as divinylbenzene.

The above-described alkyl methacrylate, alkyl acrylate, and other monomer may be used in combination of two or more species thereof, if necessary.

From the viewpoint of heat resistance of the film, the methacrylic resin preferably has a glass transition temperature of 40°C or above, and more preferably 60°C or above. The glass transition temperature is appropriately adjustable, by controlling species and ratio of the monomer.

The methacrylic resin may be prepared by alloying the monomer component thereof to polymerize by, for example, suspension polymerization, emulsion polymerization or bulk polymerization. In the polymerization, a chain transfer agent is preferably used for the purpose of obtaining a desirable level of glass transition temperature, or for the purpose of obtaining a desirable level of viscosity suitable for ensuring formability into film. Amount of use of the chain transfer agent may appropriately be determined, typically depending on species and ratio of the monomer.
Specific examples of the UV absorber include those exemplified in the general description titled

### [Hard Coat Layer].

Besides those described in the above, compounds capable of converting energy of ultraviolet radiation into vibration energy of the molecule, and emitting the vibration energy in the form of heat energy, may be used as the UV absorber. Also an agent capable of expressing an effect when combined, for example, with an antioxidant or colorant, or a photostabilizer, also known as quencher, capable of acting as a light energy converter, may additionally be used. Note that, for the case where the UV absorber is used, it is necessary to select the UV absorber showing a light absorption wavelength range not overlapping an effective wavelength of the photopolymerization initiator. When a general UV absorber is used, it is effective to use a photopolymerization initiator capable of generating a radical in the visible light region.

Two or more species of the UV absorber may be combined if necessary. Again if necessary, another UV absorber besides the above-described UV absorber, such as salicylic acid derivative, substituted acrylonitrile, or nickel complex may be contained.

Content of the UV absorber in the translucent resin layer is preferably 0.1 to 20% by mass, more preferably 1 to 15% by mass, and still more preferably 3 to 10% by mass. On the other hand, content of the UV absorber in the translucent resin layer per unit area of film is 0.17 to 2.28 g/m², and preferably 0.4 to 2.28 g/m² or more. By adjusting the content in the above-described ranges, a sufficient level of weatherability may be ensured, while preventing the roll or film from getting dirty due to bleed-out of the UV absorber.
An antioxidant may be contained in the translucent resin layer in order to prevent degradation of the translucent resin layer having the UV absorber contained therein. Specific examples of the antioxidant are exemplified by those exemplified in the general description titled [Hard Coat Layer].

It is also possible to provide the translucent resin layer with antistatic performance, by adding an antistatic agent to the translucent resin layer.
It is still also possible to add a phosphorus-containing flame retardant to the translucent resin layer. The phosphorus-containing flame retardant used herein is any one species selected from red phosphorus, triaryl phosphate ester, diaryl phosphate ester, monoaryl phosphate ester, arylphosphonic acid compound, aryl phosphine oxide compound, condensed aryl phosphate ester, halogenated alkylphosphate ester, halogen-containing condensed phosphate ester, halogen-containing condensed phosphonic ester, halogen-containing phosphorous ester, or from mixtures of two or more species of them. Specific examples include triphenyl phosphate, 9,10-dihydro-9-oxa-10-phosphaphenanthrene-10-oxide, phenylphosphonic acid, tris(β-chloroethyl) phosphate, tris(dichloropropyl) phosphate, and tris(tribromoneopentyl) phosphate.

### [Adhesive Layer]

The adhesive layer is not specifically limited, so long as it functions to enhance bonding strength between the reflective layer and the base. Accordingly, the adhesive layer is required to have bonding strength enough to bond the base and the reflective layer, heat resistance enough to endure heat in the process of forming the reflective layer typically by vacuum deposition, and smoothness enough to ensure an excellent reflective performance intrinsic to the reflective layer.

Thickness of the adhesive layer is preferably 0.01 to 3 µm from the viewpoint of bonding strength, smoothness, and reflectance of a reflective material, and more preferably 0.1 to 1 µm.

In the case where the adhesive layer is composed of a resin, the resin is not specifically limited so long as it satisfies the above-described conditions for bonding strength, heat resistance, and smoothness, and is exemplified by polyester-based resin, acryl-based resin, melamine-based resin, epoxy-based resin, polyamide-based resin, vinyl chloride-based resin, vinyl chloride vinyl acetate copolymer-based resin, which may be used independently, or in the form of mixed resin. From the viewpoint of weatherability, a mixed resin of polyester-based resin and melamine-based resin is preferable, and a thermosetting resin additionally mixed with a curing agent such as isocyanate is more preferable. Available methods of forming the adhesive layer include gravure coating, reverse coating, die coating, and any other publicly known methods of coating.

In the case where the adhesive layer is composed of a metal oxide, the adhesive layer may be formed using silicon oxide, aluminum oxide, silicon nitride, aluminum nitride, lanthanum oxide or lanthanum nitride, by various vacuum film forming methods. The methods are exemplified by resistance heating vacuum deposition, electron beam heating vacuum deposition, ion plating, ion beam-assisted vacuum deposition, and sputtering.

### [Reflective Layer]

The reflective layer used in the present invention is a layer composed, for example, of metal capable of reflecting sunlight Reflectance of the surface of the reflective layer is preferably 80% or larger, and more preferably 90% or larger. The reflective layer is preferably formed using a material containing any of elements selected from the group consisting of Al, Ag, Cr, Cu, Ni, Ti, Mg, Rh, Pt and Au. Among them, the material preferably contains Al or Ag as a major component from the viewpoint of reflectance and corrosion resistance. It is also preferable to form two or more layers of film of these metals. In the present invention, it is particularly preferable to form a silver reflective layer mainly composed of silver.

It is also preferable to provide, over the reflective layer, layers of metal oxides such as SiO₂ and TiO₂ in this order so as to further improve the reflectance.

Both of wet process and dry process are available as methods of forming the reflective layer used in the present invention (for example, silver reflective layer).

The wet process is a general term for plating, by which metal is deposited from solution to form a film. Specific examples include silver mirror reaction.

On the other hand, the dry process is a general term for vacuum film forming, and specific examples include resistance heating vacuum deposition, electron beam heating vacuum deposition, ion plating, ion beam-assisted vacuum deposition, and sputtering. Among others, preferably used in the present invention is a vacuum deposition that can be adapted to a roll-to-roll continuous film formation. In short, in the method for producing the film mirror of the present invention, the reflective layer is preferably formed by vacuum deposition of silver.

Thickness of the reflective layer is preferably 10 to 200 nm from the viewpoint of reflectance, and more preferably 30 to 150 nm.

### [Anticorrosive Layer]

The anticorrosive layer is preferably provided in adjacent to the reflective layer and contains an anticorrosive for silver. The anticorrosive preferably used herein is roughly classified into anticorrosive having a silver adsorbing group, and anticorrosive having an antioxidative performance (also referred to as antioxidant).

Now, "corrosion" is defined as a phenomenon such that metal (silver) is eroded in a chemical or electrochemical manner by an environmental substance surrounding it, or metal is degraded in the material performance (see JIS Z0103-2004).

The film mirror for solar thermal power generation is preferably embodied so that the anticorrosive layer contains the anticorrosive having a silver adsorptive group, or the antioxidant.

It is preferable to adjust content of the anticorrosive in the range from 0.1 to 1.0/m² in general, although the optimum amount may vary depending on compounds to be used.

### <Anticorrosive Having Silver Adsorptive Group>

Anticorrosive having a group adsorptive to silver is preferably at least one species selected from amines and derivatives thereof, compound having a pyrrole ring, compound having a trizaole ring, compound having pyrazole ring, compound having a thiazole ring, compound having an imidazole ring, compound having an indazole ring, copper chelete compounds, thioureas, compound having a mercapto group, and naphthalene-based compound, or from mixtures of them.

### <Antioxidant>

Also antioxidant may be used as the anticorrosive contained in the anticorrosive layer.

Phenolic antioxidant, thiol-based antioxidant and phosphite-based antioxidant are preferably used as the antioxidant.

In the present invention, the antioxidant may be used in combination with a photostabilizer.

### [Base]

A resin film or glass film may be used as the base in the present invention.

### <Resin Film>

A resin film for composing the base may be any of various publicly known resin films. Examples include cellulose ester-based film, polyester-based film, polycarbonate-based film, polyallylate-based film, polysulfone (including polyethersulfone)-based film, polyester films such as polyethylene terephthalate and polyethylene naphthalate, polyethylene film, polypropylene film, cellophane, cellulose diacetate film, cellulose triacetate film, cellulose acetate propionate film, cellulose acetate butyrate film, polyvinylidene chloride film, polyvinyl alcohol film, ethylene vinyl alcohol film, syndiotactic polystyrene-based film, polycarbonate film, norbomene-based resin film, polymethylpentene film, polyether ketone film, polyether ketone imide film, polyamide film, fluorine-containing resin film, nylon film, polymethyl methacrylate film, and acryl film.

Of these, polycarbonate-based film, polyester-based film, norbornene-based resin film, and cellulose ester-based film are preferable. In particular, polyester-based film and cellulose ester-based film are preferably used. The films may be manufactured either by melt casting or solvent casting.

Thickness of the resin film is preferably adjusted to an appropriated value, depending on, for example, species of the resin and purposes. For example, the thickness is generally adjusted to the range from 10 to 300 µm, preferably from 20 to 200 µm, and more preferably from 30 to 100 µm.

### <Glass Film>

The base, when composed of a glass film, preferably has a thickness of 1.0 to 200 µm.

The glass film is preferably from a glass roll obtained by the down-draw process. More specifically, the glass film is preferably formed by the down-draw process, with the front and back surfaces thereof exposed, then taken up into a roll together with a protective sheet stacked thereon, and unrolled for use, as disclosed in Japanese Laid-Open Patent Publication No. 2010-132347.

In this configuration, the glass film is formed by the down-draw process, with the front and back surfaces thereof exposed, then taken up into a glass roll together with the protective sheet stacked thereon. Accordingly, there is no need of providing a film forming process for forming a protective sheet such as a polymer layer on the front and back surfaces of the glass film before packaging, and also there is no need of providing a removal process for removing the protective sheet such as a polymer layer from the surfaces of the glass film after unpacking.

Since the process time before the packaging may be shortened by the time previously spent for forming the protective sheet, so that an opportunity that the glass film may catch any foreign matter on the front and back surfaces thereof may be minimized, and so that there is no event of residue of the protective sheet remained after unpacking. As a consequence, the front and back surfaces of the glass film manufactured by the down-draw process may be kept at a good level of cleanliness. It is also advantageous that the front and back surfaces ascribable to the down-draw process may be kept in a high level of cleanliness without polishing, unlike the glass film formed by the float process which needs post-process polishing.

The exposed front and back surfaces of the glass film are protected by the protective sheet when kept in the form of glass roll. In addition, since the front and back surfaces of the glass film are native surfaces having no protective sheet, such as polymer layer formed thereon, so that the glass film is less likely to stick to the protective sheet in the rolled state. Accordingly, the glass film may be suppressed from being damaged in the rolled state in a reliable manner, and also after being unpacked as possible, since the glass film and the protective sheet are kept readily separable.

The glass film may readily be sent to the next process without causing warping, even after being kept in a rolled state for a long duration of time. Since the taking-up process can produce a long-sheet glass film, so that the film may be cut into pieces of arbitrary length to produce a variety of sizes of substrate, and the glass film may be prevented from being wasted.

Thickness of the glass film is preferably in the range from 1.0 to 200 µm as described in the above, more preferably from 30 µm or larger and 150 µm or smaller, and still more preferably from 50 to 120 µm. The glass film having a thickness of smaller than 1 µm may break under tension in the process of taking up into the roll, whereas the glass film having a thickness exceeding 200 µm may make it difficult to be taken up into the roll.

By adjusting the thickness in the above-described ranges, the glass film will have an appropriate level of flexibility. Accordingly, the glass film may be relieved from unnecessarily large stress exerted thereon in the process of taking-up, and thereby prevented from being damaged.

In the configuration described in the above, the glass film preferably has an arithmetic average roughness Ra, at the both end faces in the width-wise direction, of 0.1 µm or smaller. The "arithmetic average roughness Ra" herein means a value measured by a method conforming to JIS B0601:2001.

In this way, both end faces, in the width-wise direction, of the glass film may be given an appropriate level of smoothness. Accordingly, the glass film may be prevented from being finely scratched on both end faces thereof in the process of taking-up into the roll, and thereby prevented from being damaged from both end faces. Since glass powder (cullet) possibly generated due to fine scratches on the end faces of the glass film may be reduced, this will be very advantageous in terms of ensuring cleanliness on the front and back surfaces of the glass film. Even if the end faces of the glass film and protective sheet were brought into contact, the end faces of the glass film will not be bitten into the protective sheet nor caught up, successfully keeping a good level of separability between the glass film and the protective sheet.

In the configuration described in the above, both end faces of the glass film are preferably composed of cross section given by laser cutting. The laser cutting herein includes not only laser fusion cutting, but also laser cleavage cutting.

### (Reflecting Device for Solar Thermal Power Generation)

The reflecting device for solar thermal power generation is composed of at least the film mirror for solar thermal power generation and a support body. The reflecting device for solar thermal power generation preferably has a sticky layer for bonding the film mirror and the support body

### [Support Body]

The support body used for the reflecting device for solar thermal power generation of the present invention is exemplified by metal sheet, resin sheet or composite sheet of metal and resin. Examples of available metal plate include steel sheet, copper sheet, aluminum sheet, aluminum-plated steel sheet, aluminum base alloy-plated steel sheet, copper-plated steel sheet, tin-plated steel sheet, chromium-plated steel sheet, stainless steel sheet, all characterized by large thermal conductivity. Examples of available resin sheet include acrylic resin sheet, urethane-based resin sheet, polystyrene-based resin sheet, polyimide-based resin sheet, phenolic resin sheet, polycarbonate-based resin sheet, alicyclic hydrocarbon-based resin sheet, polypropylene-based resin sheet, polyolefin-based resin sheet, melamine-based resin sheet, and ABS-based resin sheet. Examples of available composite sheet of metal and resin include stack of a metal sheet and a resin sheet, and stack of a metal sheet and foam resin. The foam resin herein means porous resin, and is exemplified by those having polystyrene-based, polyolefin-based, polyurethane-based, melamine resin-based, and polyimide-based compositions.

Thickness of these support bodies is preferably 0.05 mm to 3 mm or around, in view of handlability, thermal conductivity and heat capacity.

### [Tacky Layer]

The sticky layer for bonding the support body and the film mirror for solar thermal power generation in the reflecting device for solar thermal power generation is not specifically limited, and any of dry laminate agent, wet laminate agent, adhesion agent, heat seal agent and hot melt agent may be used.

For example, polyester-based resin, urethane-based resin, polyvinyl acetate-based resin, acrylic resin, or nitrile rubber may be used.

While methods of lamination are not specifically limited, it is preferable to conduct the lamination by the roll process under continuous operation, from the viewpoint of economy and productivity.

Thickness of the sticky layer is preferably adjusted to 1 to 50 µm or around in general, from the viewpoint of adhesive effect and drying speed.

Specific examples of a sticky agent used for composing the sticky layer include "SK-Dyne Series" from Soken Chemical and Engineering Co. Ltd., "Oribain BPW Series, BPS Series" from Toyo Ink Co. Ltd., and "Arkon", "Super Ester", and "Hypale" from Arakawa Chemical Industries, Ltd.

The hard coat layer containing the fluorine atom-containing leveling agent on the present invention is adoptable not only to the film mirror, but also to other functional films such as heat insulating film, antifouling film, and protective film.

### EXAMPLE

The present invention will now be explained into detail referring to Examples, but without limiting the present invention. In the description of Examples, notations of "part" and "%" mean "part by mass" and "% by mass", respectively, unless otherwise specifically noted.

### Examples

### «Manufacturing of Reflecting Device for Solar Thermal Power Generation»

### [Manufacturing of Film Mirror For Solar Thermal Power Generation 1-1]

A bi-oriented polyester film (polyethylene terephthalate film, 100 µm thick) was used as the base. On one surface of the polyethylene terephthalate film, a resin composed of a 20:1:1:2 (solid content basis) mixture of a polyester-based resin, a melamine-based resin, a TDI-based isocyanate, and a HMDI-based isocyanate was coated by gravure coating to thereby form an anchor layer of 0.1 µm thick, and thereon a silver reflective layer of 80 nm thick was formed as the reflective layer by vacuum deposition. On the silver reflective layer, an anti-corrosive layer of 0.1 µm thick was formed by coating, by gravure coating, a mixture composed of a 10:2 mixture (ratio by mass, based on the solid contents of resins) of polyester-based resin and toluene diisocyanate-based resin, added with 10% by mass, relative to the solid contents of resins, ofTinuvin 234(Ciba Japan Ltd.) as an anticorrosive.

Next, an acrylic resin adhesive (from Showa Highpolymer Co. Ltd.) was coated to thereby form an adhesive layer of 10 µm thick, and thereon an acrylic resin film (KORAD CLRAR05005, from Polymer Extruded Products, Inc.) containing a UV absorber was stacked as an acrylic resin layer of 50 µm thick. Next, on the acrylic resin film, Lioduras LCH (from Toyo Ink Co. Ltd.), added with 0.1% by mass ZX-049 (from Fuji Kasei Kogyo Co. Ltd.) as a fluorine-containing leveling agent relative to the solid resin content, was coated by gravure coating to a wet thickness of 40 µm, and the coating was irradiated by UV using a UV conveyer (light source; high pressure mercury lamp, illuminance; 100 mW/cm²) to form a hard coat layer. A film mirror for solar thermal power generation 1-1 was thus produced.

### [Manufacturing of Film Mirror for Solar Thermal Generation 2-1]

A film mirror for solar thermal power generation 2-1 was produced similarly to the sample 1-1, except that 10% by mass of ZX-049 (from Fuji Kasei Kogyo Co. Ltd.) was used relative to the solid resin content.

### [Manufacturing of Film Mirror for Solar Thermal Generation 3-1]

A film mirror for solar thermal power generation 3-1 was produced similarly to the film mirror for solar thermal power generation 1-1, except that 2% by mass, relative to the solid resin content, of Tinuvin 477 (from Ciba Japan Ltd.) as a triazine-based UV absorber was added to the hard coat layer.

### [Manufacturing of Film Mirrors for Solar Thermal Generation 4-1 to 7-1]

Film mirrors for solar thermal power generation 4-1 to 7-1 were produced similarly to the film mirror for solar thermal power generation 1-1, except that 20% by mass, relative to the solid resin content, of titanium oxide STR-60, zinc oxide NANOFINE-50 (the both from Sakai Chemical Industry Co. Ltd.), cerium oxide CeO-X01 (from IOX Co. Ltd.), iron oxide Sicotrans Red L2815 (from BASF GmbH), all being the inorganic UV absorbers, were added to the hard coat layer while varying the species as listed in Table 1.

### [Manufacturing of Film Mirror for Solar Thermal Generation 8-1]

A film mirror for solar thermal power generation 8-1 was produced similarly to the film mirror for solar thermal power generation 3-1, except that 20% by mass, relative to the solid resin content, of titanium oxide STR-60 (from Sakai Chemical Industry Co. Ltd.) as an inorganic UV absorber was added to the hard coat layer, in addition to the triazine-based UV absorber.

### [Manufacturing of Film Mirror for Solar Thermal Generation 9-1]

A film mirror for solar thermal power generation 9-1 was produced similarly to the film mirror for solar thermal power generation 3-1, except that 10% by mass, relative to the solid resin content, of ZX-049 (from Fuji Kasei Kogyo Co. Ltd.) was added.

### [Manufacturing of Film Mirrors for Solar Thermal Generation 10-1 to 13-1]

Film mirrors for solar thermal power generation 10-1 to 13-1 were produced similarly to the film mirrors for solar thermal power generation 4-1 to 7-1, except that 10% by mass, relative to the solid resin content, of ZX-049 (from Fuji Kasei Kogyo Co. Ltd.) was added.

### [Manufacturing of Film Mirror for Solar Thermal Generation 14-1]

A film mirror for solar thermal power generation 14-1 was produced similarly to the film mirror for solar thermal power generation 8-1, except that 10% by mass, relative to the solid resin content, of ZX-049 (from Fuji Kasei Kogyo Co. Ltd.) was added.

### [Manufacturing of Film Mirrors for Solar Thermal Generation 15-1 to 18-1]

Film mirrors for solar thermal power generation 15-1 to 18-1 were produced similarly to the film mirrors for solar thermal power generation 4-1 to 7-1, except that 1% by mass, relative to the solid resin content, of Irganox 1010 (from Ciba Japan Ltd.) was added as an antioxidant to the hard coat layer.

### [Manufacturing of Film Mirror for Solar Thermal Generation 19-1]

A film mirror for solar thermal power generation 19-1 was produced similarly to the film mirror for solar thermal power generation 8-1, except that 1% by mass, relative to the solid resin content, of Irganox 1010 (from Ciba Japan Ltd.) was added as an antioxidant to the hard coat layer.

### [Manufacturing of Film Mirror for Solar Thermal Generation 20-1]

A film mirror for solar thermal power generation 20-1 was produced similarly to the film mirror for solar thermal power generation 9-1, except that 1 % by mass, relative to the solid resin content, of Irganox 1010 (from Ciba Japan Ltd.) was added as an antioxidant to the hard coat layer.

### [Manufacturing of Film Mirrors for Solar Thermal Generation 21-1 to 24-1]

Film mirrors for solar thermal power generation 21-1 to 24-1 were produced similarly to the film mirrors for solar thermal power generation 15-1 to 18-1, except that 10% by mass, relative to the solid resin content, of ZX-049 (from Fuji Kasei Kogyo Co. Ltd.) was added.

### [Manufacturing of Film Mirrors for Solar Thermal Generation 25-1 to 27-1]

Film mirrors for solar thermal power generation 25-1 to 27-1 were produced similarly to the film mirror for solar thermal power generation 19-1, except that 1, 4, and 10% by mass, relative to the solid resin content, of ZX-049 (from Fuji Kasei Kogyo Co. Ltd.) were respectively added as listed in Table 2.

### [Manufacturing of Film Mirrors for Solar Thermal Generation 28-1, 29-1]

Film mirrors for solar thermal power generation 28-1, 29-1 were produced similarly to the film mirrors for solar thermal power generation 1-1, 2-1, except that ZX-017 (from Fuji Kasei Kogyo Co. Ltd.), being a fluorine-containing leveling agent, was used as the leveling agent in place and by the same amount of ZX-049, again being a fluorine-containing leveling agent.

### [Manufacturing of Film Mirrors for Solar Thermal Generation 30-1, 31-1]

Film mirrors for solar thermal power generation 30-1, 31-1 were produced similarly to the film mirrors for solar thermal power generation 25-1, 26-1, except that ZX-017 (from Fuji Kasei Kogyo Co. Ltd.), being a fluorine-containing leveling agent, was used as the leveling agent in place and by the same amount of ZX-049, again being a fluorine-containing leveling agent.

### [Manufacturing of Film Mirrors for Solar Thermal Generation 32-1, 33-1]

Film mirrors for solar thermal power generation 32-1, 33-1 were produced similarly to the film mirrors for solar thermal power generation 1-1, 2-1, except that Megafac RS-75 (from DIC Corporation), being a fluorine-containing leveling agent, was used as the leveling agent in place and by the same amount of ZX-049, again being a fluorine-containing leveling agent.

### [manufacturing of Film Mirrors for Solar Thermal Generation 34-1, 35-1]

Film mirrors for solar thermal power generation 34-1, 35-1 were produced similarly to the film mirrors for solar thermal power generation 25-1, 26-1, except that Megafac RS-75 (from DIC Corporation), being a fluorine-containing leveling agent, was used as the leveling agent in place and by the same amount of ZX-049, again being a fluorine-containing leveling agent.

### [Manufacturing of Film Mirror for Solar Thermal Generation 36-1]

A film mirror for solar thermal power generation 36-1 was produced similarly to the film mirror for solar thermal power generation 1-1, except that 0.05% by mass, relative to the solid resin content, of ZX-049 (from Fuji Kasei Kogyo Co. Ltd.) was added.

### [Manufacturing of Film Mirror for Solar Thermal Generation 37-1]

A film mirror for solar thermal power generation 37-1 was produced similarly to the film mirror for solar thermal power generation 1-1, except that 12% by mass, relative to the solid resin content, of ZX-049 (from Fuji Kasei Kogyo Co. Ltd.) was added.

### [Manufacturing of Film Mirror for Solar Thermal Generation 38-1]

A film mirror for solar thermal power generation 38-1 was produced similarly to the film mirror for solar thermal power generation 15-1, except that 0.05% by mass, relative to the solid resin content, of ZX-049 (from Fuji Kasei Kogyo Co. Ltd.) was added.

### [Manufacturing of Film Mirror for Solar Thermal Generation 39-1]

A film mirror for solar thermal power generation 39-1 was produced similarly to the film mirror for solar thermal power generation 15-1, except that 12% by mass, relative to the solid resin content, of ZX-049 (from Fuji Kasei Kogyo Co. Ltd.) was added.

### [Manufacturing of Film Mirror for Solar Thermal Generation 40-1]

A film mirror for solar thermal power generation 40-1 was produced similarly to the film mirror for solar thermal power generation 1-1, except that BYK-345 (from BYK Chemie Japan), being a non-fluorine-containing leveling agent having a hydrophilic group, was used as the leveling agent in place and by the same amount of ZX-049, being a fluorine-containing leveling agent.

### [Manufacturing of Film Mirror for Solar Thermal Generation 41-1]

A film mirror for solar thermal power generation 41-1 was produced similarly to the film mirror for solar thermal power generation 2-1, except that BYK-345 (from BYK Chemie Japan), being a non-fluorine-containing leveling agent having a hydrophilic group, was used as the leveling agent in place and by the same amount of ZX-049, being a fluorine-containing leveling agent

### [Manufacturing of Film Mirror for Solar Thermal Generation 42-1]

A film mirror for solar thermal power generation 42-1 was produced similarly to the film mirror for solar thermal power generation 15-1, except that BYK-345 (from BYK Chemie Japan), being a non-fluorine-containing leveling agent having a hydrophilic group, was used as the leveling agent in place and by the same amount of ZX-049, being a fluorine-containing leveling agent

### [Manufacturing of Film Mirror for Solar Thermal Generation 43-1]

A film mirror for solar thermal power generation 43-1 was produced similarly to the film mirror for solar thermal power generation 21-1, except that BYK-345 (from BYK Chemie Japan), being a non-fluorine-containing leveling agent having a hydrophilic group, was used as the leveling agent in place and by the same amount of ZX-049, being a fluorine-containing leveling agent

Note that the film mirrors for solar thermal power generation 1-1 to 43-1 correspond to the configuration illustrated in FIG 1.
On the other hand, film mirrors for solar thermal power generation 1-2 to 43-2 configured as illustrated in FIG 2, showing a configuration similar to that of the film mirrors for solar thermal power generation 1-1 to 43-1 but without the adhesive layer, were produced as follows. Note that, the film mirrors for solar thermal power generation, whose names have the same numeral before hyphen (-), have the same composition of the hard coat

### [Manufacturing of Film Mirror for Solar Thermal Generation 1-2]

A biaxially-oriented polyester film (polyethylene terephthalate film,100 µm thick) was used as the base. On one surface of the polyethylene terephthalate film, a resin composed of a 20:1:1:2 (solid content basis) mixture of a polyester-based resin, a melamine-based resin, a TDI-based isocyanate, and a HMDI-based isocyanate was coated by gravure coating to thereby form an anchor layer of 0.1 µm thick, and thereon a silver reflective layer of 80 nm thick was formed as the reflective layer by vacuum deposition. On the silver reflective layer, an anti-corrosive layer of 0.1 µm thick was formed by coating, by gravure coating, a resin mixture composed of a 10:2 mixture (ratio by mass, based on the solid contents of resins) of polyester-based resin and toluene diisocyanate-based resin, added with 10% by mass, relative to the solid contents of resins, of Tinuvin 234(Ciba Japan Ltd.) as an anticorrosive.

Next, over the anticorrosive layer, a translucent resin layer containing a UV absorber was formed by dissolving an acrylic resin (Acrypet VH, from Mitsubishi Rayon Co. Ltd.) and a UV absorber (Tinuvin 477, from BASF GmbH), at a ratio of solid content of 95:5, into MEK so as to adjust a solid content to 20%, and by coating the mixture using an extrusion coater to thereby form a 30 µm thick film, followed by drying (90°C, 1 min.).
Next, over the translucent resin layer, Lioduras LCH (from Toyo Ink Co. Ltd.), added with 0.1% by mass ZX-049 (from Fuji Kasei Kogyo Co. Ltd.) as a fluorine-containing leveling agent relative to the solid resin content, was coated by gravure coating to a wet thickness of 40 µm, and the coating was irradiated by UV using a UV conveyer (light source; high pressure mercury lamp, illuminance; 100mW/cm²) to form a hard coat layer. A film mirror for solar thermal power generation 1-2 was thus produced.

### [Manufacturing of Film Mirrors for Solar Thermal Generation 2-2 to 43-2]

Film mirrors for solar thermal power generation 2-2 to 43-2 were produced similarly to the film, mirror for solar thermal power generation 1-2, in which the compositions of the hard coat layer and the methods of forming the hard coat layer were respectively same as those for the film mirrors for solar thermal power generation 2-1 to 43-1 having the same numeral before hyphen (-).

### [Manufacturing of Reflecting Devices for Solar Thermal Power Generation1-1 to 43-1 and 1-2 to 43-2]

On each of the film mirrors for solar thermal power generation 1-1 to 43-1 and 1-2 to 43-2 produced as described in the above, an acrylic resin adhesive (from Showa Highpolymer Co. Ltd.) was coated over the surface opposite to the surface having the reflective layer formed thereon, to thereby form a sticky layer of 10 µm thick, and each film mirror for solar thermal power generation was bonded to an aluminum sheet (from Sumitomo Light Metal Industries, Ltd.) of 0.1 mm thick, 4 cm long and 5 cm wide, while placing the sticky layer in between. The reflecting devices for solar thermal power generation 1-1 to 43-1 and 1-2 to 43-2 were thus produced.

### «Evaluation of Reflecting Devices for Solar Thermal Power Generation»

Weatherability of each of the reflecting devices for solar thermal power generation produced in the above was evaluated in terms of scratch resistance after heat moisture treatment, scratch resistance after UV degradation treatment and antifouling property of the methods described below.

### [Scratch Resistance after Heat Moisture Treatment]

Each sample was kept in a 50°C atmosphere for 10 days, using a thermohygrostat chamber LH43 from Nagano Science Co. Ltd., while being sprayed with pure water by 100 ml/cm² with an atomizer every 6 hours. The outermost layer of the film mirror was then scoured back and forth 10 times using a #0000 steel wool under a 1 kg/cm² load, with a stroke of 100 mm at a speed of 30 mm/sec, and scratch resistance after the heat moisture treatment was evaluated, according to the criteria below.

⊚: no scratch line
○:1 to 5 scratch lines
Δ: 6 to 10 scratch lines
×: more than 10 scratch lines

### [Scratch resistance after UV Degradation Treatment]

Each sample was irradiated by UV using EYE Super UV tester from Iwasaki Electric Co. Ltd., under an environment of 65°C for 96 hours, the outermost layer of the film mirror was then scoured back and forth 10 times using a #0000 steel wool under a 1 kg/cm² load, with a stroke of 100 mm at a speed of 30 mm/sec, and the scratch resistance after UV degradation treatment was evaluated according to the criteria below:

⊚: no scratch line
○: 1 to 5 scratch lines
Δ: 6 to 10 scratch lines
×: more than 10 scratch lines

### <Measurement of Regular Reflectance>

A spectrophotometer UV265 from Shimadzu Corporation was modified by attaching an auxiliary reflectometer of integrating sphere, the angle of incidence of incident light was adjusted to 5°away from the normal line of the reflective surface, and thereby the regular reflectance of each sample was measured at a reflection angle of 5°. Evaluation was made based on an average reflectance over a range from 350 nm 700 nm.

### [Reflectance after UV Degradation Treatment]

Each sample was irradiated by UV using EYE Super UV tester from Iwasaki Electric Co. Ltd., under an environment of 65°C for 7 days, the regular reflectance was measured, an average value of the regular reflectance after UV irradiation was calculated assuming the value before the UV irradiation as 100%, and reflectance after the UV degradation treatment was evaluated according the criteria below.

⊚: average value of regular reflectance is 90% or larger,
o: average value of regular reflectance is 85% or larger, and smaller than 90%:
Δ: average value of regular reflectance is 80% or larger, and smaller than 85%; and
×: average value of regular reflectance is smaller than 80%.

### [Antifouling Property]

Each sample was bonded an aluminum base to thereby manufacture the reflecting device for solar thermal power generation, placed in a desert area characterized by an average temperature of 40°C and a dew point of 20°C in the daytime, and an average temperature of 15°C and a dew point of 10°C in the nighttime, 1 m above the ground surface, and inclined at 45° to the ground surface, and left to stand for one month. The reflectance was measured under the conditions described in the above, and antifouling property was evaluated according to the criteria below.

⊚: average value of regular reflectance is 90% or larger,
o: average value of regular reflectance is 85% or larger, and smaller than 90%:
Δ: average value of regular reflectance is 80% or larger, and smaller than 85%; and
×: average value of regular reflectance is smaller than 80%.

Results of evaluation are shown in Tables 1 and 2. In Tables 1 and 2, the reference numerals of the reflecting devices for solar thermal power generation were simply denoted as device No.
It was found that, results of evaluation of the film mirrors for solar thermal power generation 1-1 to 43-1 configured as illustrated in FIG 1, and results of evaluation of the film mirrors for solar thermal power generation 1-2 to 43-2 configured without using the adhesive layer as illustrated in FIG 2 were identical, when the hard coat compositions were same.

**[Table 1]**

| Device No. | Hard Coat Composition | | | | Evaluation | | | | Remarks |
|---|---|---|---|---|---|---|---|---|---|
| | Leveling Agent | | UV Absorber | Antioxidant | Scratch Resistance (after heat moisture treatment) | Scratch Resistance (after UV degradation treatment) | Reflectance (afterUV degradation treatment) | Anti-fouling Property | |
| | Species | Amount of addition (% by mass) | | | | | | | |
| 1 | ZX-049 | 0.1 | none | none | ○ | ○ | ○ | ○ | Example |
| 2 | ZX-049 | 10 | none | none | ○ | ○ | ○ | ○ | Example |
| 3 | ZX-049 | 0.1 | Tinuvin 477 | none | ○ | ○ | ⊚ | ○ | Example |
| 4 | ZX-049 | 0.1 | titanium oxide | none | ○ | ○ | ⊚ | ○ | Example |
| 5 | ZX-049 | 0.1 | zinc oxide | none | ○ | ○ | ⊚ | ○ | Example |
| 6 | ZX-049 | 0.1 | cerium oxide | none | ○ | ○ | ⊚ | ○ | Example |
| 7 | ZX-049 | 0.1 | iron oxide | none | ○ | ○ | ⊚ | ○ | Example |
| 8 | ZX-049 | 0.1 | Tinuvin477+ titanium oxide | none | ○ | ○ | ⊚ | ○ | Example |
| 9 | ZX-049 | 10 | Tinuvin477 | none | ○ | ○ | ⊚ | ○ | Example |
| 10 | ZX-049 | 10 | titanium oxide | none | ○ | ○ | ⊚ | ○ | Example |
| 11 | ZX-049 | 10 | zinc oxide | none | ○ | ○ | ⊚ | ○ | Example |
| 12 | ZX-049 | 10 | cerium oxide | none | ○ | ○ | ⊚ | ○ | Example |
| 13 | ZX-049 | 10 | iron oxide | none | ○ | ○ | ⊚ | ○ | Example |
| 14 | ZX-049 | 10 | Tinuvin477+ titanium oxide | none | ○ | ○ | ⊚ | ○ | Example |
| 15 | ZX-049 | 0.1 | titanium oxide | Irganox 1010 | ○ | ⊚ | ⊚ | ○ | Example |
| 16 | ZX-049 | 0.1 | zinc oxide | Irganox 1010 | ○ | ⊚ | ⊚ | ○ | Example |
| 17 | ZX-049 | 0.1 | cerium oxide | Irganox 1010 | ○ | ⊚ | ⊚ | ○ | Example |
| 18 | ZX-049 | 0.1 | iron oxide | Irganox 1010 | ○ | ⊚ | ⊚ | ○ | Example |
| 19 | ZX-049 | 0.1 | Tinuvin477+ titanium oxide | Irganox 1010 | ○ | ⊚ | ⊚ | ○ | Example |
| 20 | ZX-049 | 10 | Tinuvin477 | Irganox 1010 | ○ | ⊚ | ⊚ | ○ | Example |
| 21 | ZX-049 | 10 | titanium oxide | Irganox 1010 | ○ | ⊚ | ⊚ | ○ | Example |
| 22 | ZX-049 | 10 | zinc oxide | Irganox 1010 | ○ | ⊚ | ⊚ | ○ | Example |

**[Table 2]**

| Device No. | Hard Coat Composition | | | | Evaluation | | | | Remarks |
|---|---|---|---|---|---|---|---|---|---|
| | Leveling Agent | | UV Absorber | Antioxidant | Scratch Resistance (after heat moisture treatment) | Scratch Resistance (after UV degradation treatment) | Reflectance (after UV degradation treatment) | Anti-fouling Property | |
| | Species | Amount of addition (% by mass) | | | | | | | |
| 23 | ZX-049 | 10 | cerium oxide | Irganox 1010 | ○ | ⊚ | ⊚ | ○ | Example |
| 24 | ZX-049 | 10 | iron oxide | Irganox 1010 | ○ | ⊚ | ⊚ | ○ | Example |
| 25 | ZX-049 | 1 | Tinuvin 477 +titanium oxide | Irganox 1010 | ⊚ | ⊚ | ⊚ | ⊚ | Example |
| 26 | ZX-049 | 4 | Tinuvin 477 +titanium oxide | Irganox 1010 | ⊚ | ⊚ | ⊚ | ⊚ | Example |
| 27 | ZX-049 | 10 | Tinuvin 477 +titanium oxide | Irganox 1010 | ○ | ⊚ | ⊚ | ○ | Example |
| 28 | ZX-017 | 0.1 | none | none | ○ | ○ | ○ | ○ | Example |
| 29 | ZX-017 | 10 | none | none | ○ | ○ | ○ | ○ | Example |
| 30 | ZX-017 | 1 | Tinuvin 477 +titanium oxide | Irganox 1010 | ⊚ | ⊚ | ⊚ | ⊚ | Example |
| 31 | ZX-017 | 4 | Tinuvin 477 +titanium oxide | Irganox 1010 | ⊚ | ⊚ | ⊚ | ⊚ | Example |
| 32 | RS-75 | 0.1 | none | none | ○ | ○ | ○ | ○ | Example |
| 33 | RS-75 | 10 | none | none | ○ | ○ | ○ | ○ | Example |
| 34 | RS-75 | 1 | Tinuvin 477 +titanium oxide | Irganox 1010 | ⊚ | ⊚ | ⊚ | ⊚ | Example |
| 35 | RS-75 | 4 | Tinuvin 477 +titanium oxide | Irganox 1010 | ⊚ | ⊚ | ⊚ | ⊚ | Example |
| 36 | ZX-049 | 0.05 | none | none | × | × | × | Δ | Comparative Example |
| 37 | ZX-049 | 12 | none | none | × | × | × | Δ | Comparative Example |
| 38 | ZX-049 | 0.05 | titanium oxide | Irganox 1010 | × | Δ | Δ | Δ | Comparative Example |
| 39 | ZX-049 | 12 | titanium oxide | Irganox 1010 | × | Δ | Δ | Δ | Comparative Example |
| 40 | BYK-345 | 0.1 | none | none | × | × | × | × | Comparative Example |
| 41 | BYK-345 | 10 | none | none | × | × | × | × | Comparative Example |
| 42 | BYK-345 | 0.1 | titanium oxide | Irganox 1010 | × | Δ | Δ | Δ | Comparative Example |
| 43 | BYK-345 | 10 | titanium oxide | Irganox 1010 | × | Δ | Δ | Δ | Compatative Example |

As is clear from Tables 1 and 2, the reflecting devices for solar thermal power generation 1-1 to 35-1, and 1-2 to 35-2 (Inventive Examples), in which the outermost hard coat layers contain 0.1 parts by mass or more and 10 parts by mass or less, relative to the solid resin content, of the fluorine atom-containing leveling agents, showed good results of scratch resistance after moisture treatment, whereas all of the reflecting devices for solar thermal power generation 36-1 to 43-1, 36-2 to 43-2 (Comparative Examples), not containing the fluorine-containing leveling agent under the above-described conditions, showed low scratch resistance after heat moisture treatment. This is supposedly because the outermost surfaces of the hard coat layers were made water-repellent to a sufficient degree, so that the hard coat layers became less likely to be covered with water film, and thereby the hard coat layers were prevented from being degraded in Tg due to absorption of water.

It was also found that the reflecting devices for solar thermal power generation 25-1, 26-1, 30-1, 31-1, 34-1, 35-1, 25-2, 26-2, 30-2, 31-2, 34-2, and 35-2 (Inventive Examples), in which the hard coat layers are added with preferable amount of leveling agents, showed more excellent levels of scratch resistance and antifouling property.

The reflecting devices for solar thermal power generation 3-1 to 27-1, 30-1, 31-1, 34-1, 35-1, 3-2 to 27-2, 30-2, 31-2, 34-2, and 35-2 (Inventive Examples) showed higher levels of reflectance after UV degradation treatment, supposedly because the hard coat layer and the lower resin layers were prevented from being discolored due to UV degradation, by virtue of effects of the UV absorbers.

The reflecting devices for solar thermal power generation 15-1 to 27-1, 30-1, 31-1, 34-1, 35-1,15-2 to 27-2, 30-2, 31-2, 34-2, and 35-2 (Inventive Examples) showed higher levels of scratch resistance after UV degradation treatment, supposedly because the resins in the hard coat layers were prevented from oxidative degradation possibly induced by photo-excitation.

### INDUSTRIAL APPLICABILITY

The present invention thus configured may be used as the film mirror for solar thermal power generation, the method for producing a film mirror for solar thermal power generation, and the reflecting device for solar thermal power generation.

**EXPLANATION OF MARKS**

| | |
|---|---|
| 1 | base |
| 2 | anchor layer |
| 3 | reflective layer |
| 4 | anticorrosive layer |
| 5 | adhesive layer |
| 6 | translucent resin layer |
| 7 | hard coat layer |
| 10 | film mirror for solar thermal power generation |

## Claims

1. A film mirror for solar thermal power generation comprising a reflective layer over a base and a hard coat layer at an outermost surface, wherein;
the outermost hard coat layer contains a fluorine atom-containing leveling agent in 0.1 % by mass or more and 10% by mass or less relative to the solid resin content thereof

2. The film mirror for solar thermal power generation of Claim 1, wherein the outermost hard coat layer is formed by UV-curing of a UV curable resin which contains an acrylic monomer.

3. The film mirror for solar thermal power generation of Claim 1 or 2, wherein the outermost hard coat layer contains at least one of a UV absorber composed of an organic compound and a UV absorber composed of an inorganic compound.

4. The film mirror for solar thermal power generation of Claim 3, wherein the UV absorber composed of an organic compound is a triazine-based UV absorber and the UV absorber composed of an inorganic compound is at least any one of titanium oxide, zinc oxide, cerium oxide and iron oxide.

5. The film mirror for solar thermal power generation of any one of Claims 1 to 4, further comprising a layer containing an antioxidant on the base.

6. The film mirror for solar thermal power generation of any one of Claims 1 to 5, wherein the fluorine atom-containing leveling agent is any one of polyacrylate-based polymer, polyvinyl ether-based polymer and silicone-based polymer, all of which are obtained by polymerizing a fluorine atom-containing monomer unit.

7. A method for producing a film mirror for solar thermal power generation of any one of Claims 1 to 6, the method comprising:
forming the reflective layer by vacuum deposition of silver.

8. A reflecting device for solar thermal power generation comprising the film mirror for solar thermal power generation of any one of Claims 1 to 6, wherein the film mirror for solar thermal power generation is bonded to a support body through a sticky layer.
